# EUROPEAN PATENT SPECIFICATION

(11) **EP 4 272 016 B1**
(45) Date of publication and mention of the grant of the patent: **05.11.2025**
(21) Application number: 22764853.2
(22) Date of filing: 11.08.2022
(51) Int. Cl.: H04N 25/76

(54) **SOLID-STATE RADIATION SENSOR FOR THE DETECTION OF RADIATIONS, IN PARTICULAR OF PARTICLES, AND METHOD FOR THE DETECTION OF RADIATIONS, IN PARTICULAR OF PARTICLES, BY MEANS OF THE AFORESAID SOLID-STATE RADIATION SENSOR**
FESTKÖRPERSTRAHLUNGSSENSOR ZUM ERFASSEN VON STRAHLUNGEN, INSBESONDERE TEILCHEN, UND VERFAHREN ZUM ERFASSEN VON STRAHLUNGEN, INSBESONDERE TEILCHEN
CAPTEUR DE RAYONNEMENT À SEMICONDUCTEURS POUR LA DÉTECTION DE RAYONNEMENTS, EN PARTICULIER DE PARTICULES, ET PROCÉDÉ DE DÉTECTION DE RAYONNEMENTS, EN PARTICULIER DE PARTICULES, AU MOYEN DU CAPTEUR DE RAYONNEMENT À SEMICONDUCTEURS PRÉCITÉ

(30) Priority: 18.08.2021 IT 202100022025
(43) Date of publication of application: 08.11.2023
(73) Proprietor: Fondazione Bruno Kessler, 38122 Trento (IT); Casse, Gianluigi, 38122 Trento (IT)
(72) Inventor: MASSARI, Nicola, 38057 Pergine Valsugana (TN) (IT); CASSE, Gianluigi, 38122 Trento (IT)
(74) Representative: Marchioro, Paolo
(86) International application number: PCT/IB2022/057504
(87) International publication number: WO 2023/021379

(56) References cited:
- US-A1- 2010 096 556
- CARBONETTO S ET AL: "Design of an on-chip ionizing radiation differential sensor", 2015 ARGENTINE SCHOOL OF MICRO-NANOELECTRONICS, TECHNOLOGY AND APPLICATIONS (EAMTA), IEEE, 30 July 2015 (2015-07-30), pages 17 - 21, XP033217483, DOI: 10.1109/EAMTA.2015.7237372
- CARVAJAL M A ET AL: "A compact dosimetric system for MOSFETs based on passive NFC tag and smartphone", SENSORS AND ACTUATORS A: PHYSICAL, vol. 267, 2017 - 2017, pages 82 - 89, XP085248056, ISSN: 0924-4247, DOI: 10.1016/J.SNA.2017.10.015

## Description

The present invention concerns a solid-state radiation sensor for the detection of radiations, in particular of particles.

Likewise, the method for the detection of radiations, in particular of particles, by means of the aforesaid solid-state radiation sensor is also part of the invention.

It is well known that in high-energy physics it is fundamental to reconstruct the trajectory of the charged particles produced as a result of an interaction with a resolution that can reach 10 µm in the most sophisticated experiments.

To achieve this precision, two fundamental requirements must be met: the segmentation of the sensor must be such as to achieve the required precision, and the thickness of the detector (hereinafter referred to as "material budget") must be low enough to prevent multiple scattering from excessively worsening the trajectory estimate.

These requirements are partially met by the detectors in silicon or with semiconductor in general, which can be made with a pitch of a few tens of µm and with thicknesses of a few hundred µm. Silicon has a low ionisation energy, 3.6 eV, which makes it possible to obtain a detectable signal despite the fact that the thickness of the crossed material is relatively modest. These characteristics make silicon sensors very performing in tracking charged particles to reconstruct the decay vertices of short-lived particles, which decay very close (between 30 and 300 µm) to the beam interaction point. In addition, the segmentation of the sensor permits its operation even with high multiplicity of particles present in the regions close to the interaction point.

It is also known that, at present, there are essentially two types of silicon pixel sensors: the so-called in jargon hybrid pixel sensors and the active monolithic pixel sensors.

The first type of pixel sensors are devices in which the detection element and the reading electronics are made separately and then interconnected by means of the bump-bonding technique so as to form a single module. The active zone of the sensor is formed by a high-resistivity silicon layer that is generally a few hundred µm thick, which, through the application of a voltage, becomes a depleted region allowing the efficient collection of charge. When a charged particle passes through one of the pixels, it generates a number of charge carriers. If these are produced in the depletion region, they result in a current pulse above the background signal (noise), and thus produce a detectable signal. The depletion region is therefore the active zone of the detector.

The reading electronics comprises an analogue front-end circuitry directly connected to the sensitive node and configured to perform analogue/digital conversion of the signals, followed by a reading logic for transmitting the output data to the detector. This latter portion of logic is not distributed over all the pixels, but is normally located near the edge of one of the chips and manages the information of multiple pixels.

However, disadvantageously, this type of hybrid sensors has a first drawback due to the non-negligible minimum sizes of the pixels, mainly caused by the use of analogue electronics, as well as by physical limitations related to the bump-bonding connection, the sizes of which cannot be smaller than 20÷25 µm, so that the pixel pitch cannot be decreased further.

Furthermore, the high size of the pixels also results in the definition of equally high capacities which in turn, disadvantageously, increase the noise level.

In addition, further technical disadvantages of such a hybrid approach consist of high current consumptions and fairly sophisticated circuitry.

There is also the disadvantage of the "material budget": the presence of two layers (one dedicated to reading and one to the detection) disadvantageously increases the probability of scattering of the particle due to interaction with the detector itself.

The second known type of monolithic type radiation sensors are devices in which the sensor and the reading electronics are both made on the same low resistivity silicon substrate using the CMOS standard industrial process. An example of such type of radiation sensors is described by S. Carbonetto et al. in the paper "Design of an on-chip ionizing radiation differential sensor".

Having the sensor and the reading electronics on the same substrate helps reduce the amount of material with which to make the device, reducing multiple scattering and therefore improving resolution, and at the same time simplifies the assembly of the detector and makes it more robust and reliable, because the hybridization process is not necessary, and also less expensive. By polarising the substrate appropriately, the monolithic detectors can achieve complete silicon depletion, thereby increasing performance in terms of collection rate and radiation resilience.

However, even this second type of approach involves the use of a portion of analogue circuitry that has an important impact on the size of each pixel. Also in this case, there is a high circuit complexity with relative power consumption. The present invention intends to overcome all the drawbacks and limitations of the known art that have been listed.

In particular, a first object of the invention is to realize a sensor of radiations, in particular of particles, with the sensitive elements (pixels) having a much smaller size than the sensitive elements of the radiation sensors of the known type.

This therefore makes it possible to realize a radiation sensor with a higher spatial resolution than the radiation sensors of the prior art with the same sizes.

A further object of the invention is to realize a purely digital sensor. This, as a first effect, allows the reduction of complexity in terms of the number of transistors and controls.

Furthermore, a further object of the invention is to realize a radiation sensor capable of maximising, in perspective, thanks to the digital approach, the technological scalability of its constituent components.

Furthermore, an object of the invention is to realize a radiation sensor that outputs an amount of reduced information of a digital type, which therefore do not need conversion and which are quickly processable and storable, while maintaining a high spatial and temporal resolution.

Last but not least object of the invention is the realization of a radiation sensor with reduced consumptions.

The objects listed are achieved by the radiation sensor of the invention according to claim 1, to which reference will be made.

Other characteristics of the invention are described in the dependent claims. The method for the detection of radiations, in particular of particles, by means of the aforesaid radiation sensor of the invention, according to claim 10, to which reference will be made, is also part of the invention.

The objects listed will be better highlighted below during the description of a preferred, but not exclusive, embodiment of the invention which is given hereinafter with reference to the attached drawings in which:
- fig. 1 schematically depicts a radiation sensor according to a preferred embodiment of the invention;
- fig. 2 depicts the circuit diagram of a pixel belonging to the radiation sensor of fig. 1;
- fig. 3 depicts the topographic section of a pixel belonging to the radiation sensor of fig. 1;
- fig. 4 depicts a time graph of the operating cycle of the radiation sensor of the invention;
- fig. 5 depicts the characteristic graph of the value of the critical charge in relation to the value of the voltage ΔV obtained with the radiation sensor of the invention.

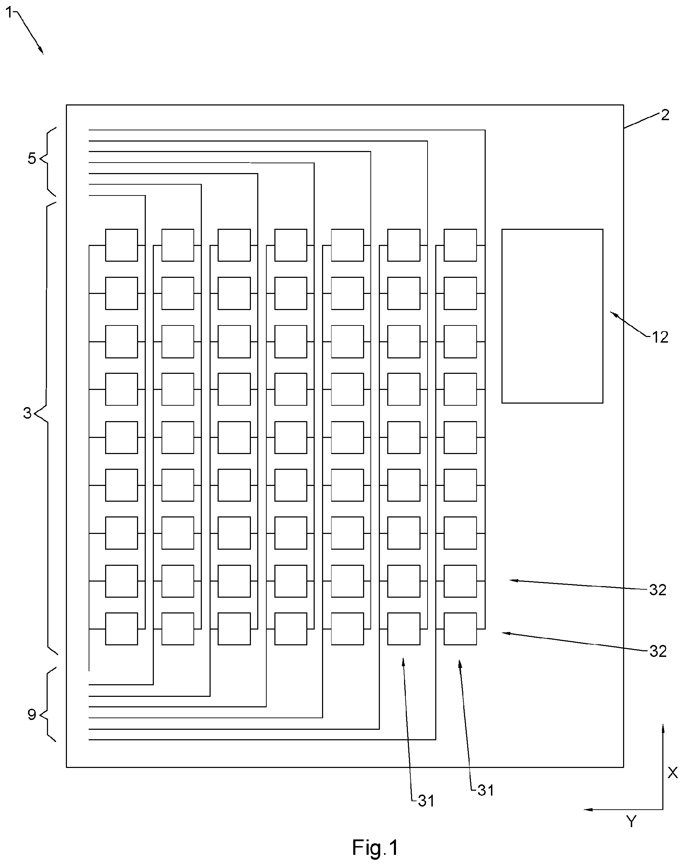

The solid-state radiation sensor of the invention, for the detection of radiations, in particular of particles, is schematically depicted in fig. 1, where it is indicated as a whole with **1.**

According to the preferred embodiment of the invention, such a solid-state radiation sensor **1** comprises a plurality of radiation-sensitive pixels **3,** made on a semiconductor substrate **2,** preferably a silicon substrate, arranged in a matrix so as to define a plurality of columns **31** along a first direction X and a plurality of rows **32** along a second direction Y.

It is not excluded, however, that such a radiation sensor **1,** as a minimum configuration, may comprise a single pixel **3.**

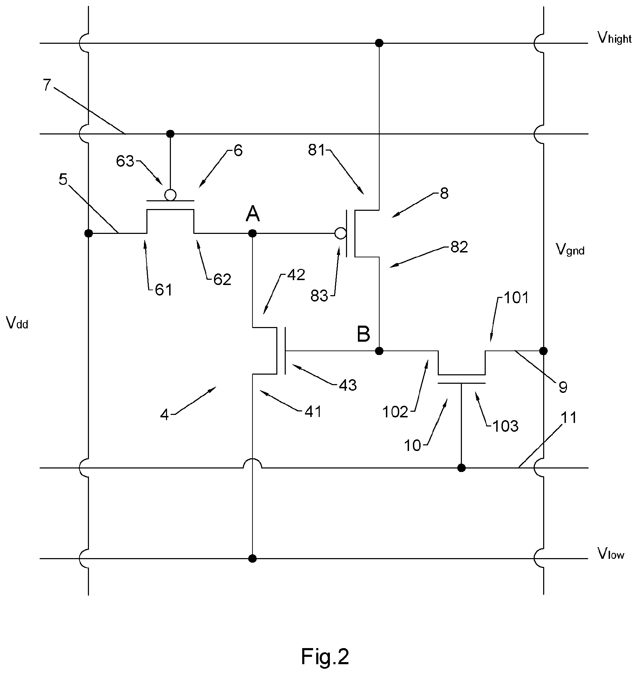

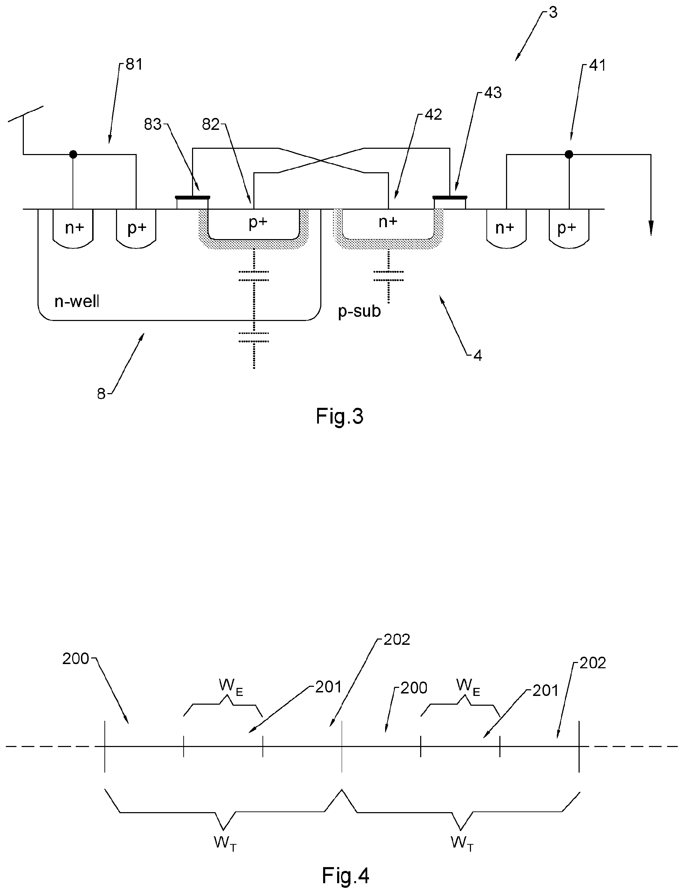

With regard to each pixel **3,** as schematically depicted in fig. 2 and in the topographic section of fig. 3, it comprises a first detection transistor **4** of the n-channel MOSFET type, having the source terminal **41** connected to a lower voltage reference **Vlow** and the drain terminal **42** connected to a first supply line **5** of voltage **Vdd** by interposition of a first electronic switch **6,** controlled by means of a first reset line **7.**

Furthermore, said pixel **3** comprises a second detection transistor **8** of the p-channel MOSFET type, having the source terminal **81** connected to a higher voltage reference **Vhigh,** the drain terminal **82** connected to a second supply line **9** of voltage **Vgnd,** by interposition of a second electronic switch **10,** controlled by a second reset line **11,** and the gate terminal **83** connected to a first common node **A** with the drain terminal **42** of the first detection transistor **4.**

Finally, the first detection transistor **4** has the gate terminal **43** connected to a second common node **B** with the drain terminal **82** of the second detection transistor **8.**

In particular, as can be noted in the diagram of fig. 2, the first common node **A** is connected exclusively to the gate terminal **83** of the second detection transistor **8,** the drain terminal **42** of the first detection transistor **4** and the first supply line **5** of voltage **Vdd,** by means of the aforesaid first electronic switch **6,** while at the second common node **B** there are connected exclusively the gate terminal **43** of the first detection transistor **4,** the drain terminal **82** of the second detection transistor **8** and the second supply line **9** of voltage **Vgnd,** by means of the aforesaid second electronic switch **10.**

The technical advantage of this arrangement will be explained below during the description of the operating steps of the radiation sensor **1** of the invention. With regard to the voltage **Vdd** and the voltage **Vgnd,** the former is set equal to the higher voltage **Vhigh** with the addition of a voltage value **ΔV,** while the voltage **Vgnd** is set equal to the lower voltage **Vlow** minus the voltage value **ΔV**. According to the preferred embodiment of the invention, in particular, the value of the voltage **ΔV** is chosen greater than 0V. Also in this case, the advantages of such a deviation between the higher voltage **Vhigh** and the voltage **Vdd** and between the lower voltage **Vlow** and the voltage **Vgnd** will be indicated below during the description of the operating steps of the radiation sensor 1 of the invention.

Even more preferably, according to the preferred embodiment of the invention, the voltage value **ΔV** is between 50 mV and 300 mV, more specifically between 150 mV and 200 mV.

Functionally, it is important to point out that the value of **ΔV** determines the discrimination threshold of the event as well as, therefore, its sensitivity to detection.

It is not excluded, however, that according to an alternative embodiment this voltage value **ΔV** is imposed equal to 0V, so in this case the voltage **Vdd** corresponds to the higher voltage value **Vhigh** and the voltage **Vgnd** corresponds to the lower voltage value **Vlow.**

With regard to the higher voltage **Vhigh** and lower voltage **Vlow values,** they are respectively imposed, preferably but not necessarily, equal to a value between 1.8V and 0.8V, preferably 1.2V and a value around 0V.

Evidently, the value chosen for **Vhigh** depends on the technology in use. More dimensionally demanding technologies may require lower values for the higher voltage **Vhigh** than those indicated above for the specific embodiment example.

With regard to the first electronic switch **6** and the second electronic switch **10,** according to the preferred embodiment, they are also two MOSFET transistors defined in the semiconductor substrate **2.**

Even more specifically, the first electronic switch **6** is a p-channel MOSFET transistor connected with the drain terminal **61** to the first supply line **5** of voltage **Vdd,** with the source terminal **62** to the drain terminal **42** of the first detection transistor **4,** then at the first common node **A,** and with the gate terminal **63** to the first reset line **7.**

Similarly, preferably but not necessarily, the second electronic switch **10** is an n-channel MOSFET transistor connected with the drain terminal **101** to the second supply line **9** of voltage **Vgnd,** with the source terminal **102** connected to the drain terminal **82** of the second detection transistor **8,** then at the second common node **B,** and with the gate terminal **103** to the second reset line **11.**

According to the preferred embodiment of the invention, as depicted in fig. 1, the radiation sensor **1** of the invention comprises a plurality of first supply lines **5** of voltage **Vdd,** distinct from each other, and a plurality of second supply lines **9** of voltage **Vgnd,** distinct from each other. Even more preferably, the radiation sensor **1** of the invention comprises a number of first supply lines **5** of voltage **Vdd** equal to the number of columns **31** of the aforesaid pixel matrix **3** and, likewise, a number of second supply lines **9** of voltage **Vgnd,** always equal to the number of columns **31** of the aforesaid pixel matrix **3.**

Each of the first supply lines **5** of voltage **Vdd** and each of the second supply lines **9** of voltage **Vgnd** is operatively connected exclusively with the pixels **3** belonging to one of the columns **31** of the pixel matrix **3.** In this way, advantageously, it is possible to define for each column **31** of pixels **3** a specific value of the voltages **Vdd** and **Vgnd,** potentially distinct from the values of the voltages **Vdd** and **Vgnd** of the remaining columns **31** of pixels **3.** In other words, in this way it is possible to vary and define the specific value of the voltage **ΔV** for each column **31** of pixels **3,** independently of the remaining columns **31.**

This advantageously makes it possible to independently determine for each pixel **3** present in the matrix the discrimination threshold of the event, as well as therefore its sensitivity to detection, thus compensating for any nonuniformities linked to threshold differences.

In an alternative embodiment, it is not excluded that the number of first supply lines **5** of voltage **Vdd** and the number of second supply lines **9** of voltage **Vgnd** may be equal to the number of rows **32** of the pixel matrix **3,** rather than to the number of columns **31,** and therefore it is not excluded that each of said first supply lines **5** of voltage **Vdd** and each of said second supply lines **9** of voltage **Vgnd** may be operatively connected exclusively to the pixels **3** belonging to a single row **32** of said pixel matrix **3.**

Still, alternatively, a different embodiment of the radiation sensor **1** of the invention could provide a number of first supply lines **5** of voltage **Vdd** equal to the number of the pixels **3** of the matrix and, likewise, a number of second supply lines **9** of voltage **Vgnd** always equal to the number of the pixels **3,** wherein each of the first supply lines **5** of voltage **Vdd** and each of the second supply lines **9** of voltage **Vgnd** is connected to one and only one of the aforesaid pixels **3.**

Furthermore, a different embodiment of the radiation sensor **1** of the invention could provide a single supply line **5** of voltage **Vdd** and a single supply line **9** of voltage **Vgnd,** both connected to all the pixels **3** belonging to the aforesaid pixel matrix **3.** Evidently, in this latter embodiment it will not be possible to distinguish the supply voltages **Vdd** and **Vgnd** imposed on the various pixels **3** of the radiation sensor **1** of the invention.

As regards, again, the radiation sensor **1** of the invention, it also comprises a logic unit **12** configured to perform in sequence and periodically:
- a pre-charging step **200,** placing in operating mode the first electronic switch **6** and the second electronic switch **10,** so as to impose on the first common node **A** the voltage **Vdd** and so as to impose on the second common node **B** the voltage **Vgnd.** Evidently, the state of operation of the first electronic switch **6** and of the second electronic switch **10** is imposed by the logic unit **12** respectively by acting on the two reset lines **7** and **11;**
- a step of exposure **201** of the pixels **3** to radiations, placing in cut-off mode the first electronic switch **6** and the second electronic switch **10,** so as to make the first common node **A** and the second common node **B** float. Also in this case, evidently, the cut-off state of the first electronic switch **6** and of the second electronic switch **10** is imposed by the logic unit **12** respectively by acting on the two reset lines **7** and **11;**
- a step of reading **202** the state of the first detection transistor **4** and of the second detection transistor **8** of each pixel **3,** so as to verify whether, during the aforesaid exposure step **201,** a radiation, in particular a particle, has actually interacted with said pixel **3.**

With regard to the exposure step **201,** it preferably has, as schematically shown in fig. 4, a time window **W_{E}** with a duration between 50 µs and 30 ms.

This window can also be increased at will or decreased outside the range reported herein up to values around a few hundred ns. Finally, it is noted that the time window **W_{E}** does not necessarily define the acquisition time of the particle, which can be extrapolated by means of higher-resolution peripheral circuits not described in the present invention.

Furthermore, it will be important, for the reasons indicated below during the description of the operation of the radiation sensor **1** of the invention, to also define a time window **W_{T}** with a predetermined duration of the entire acquisition cycle comprising the aforesaid three operating steps.

In particular, according to the preferred embodiment of the invention, said time window **W_{T}** with duration of the entire cycle is greater than the duration of the time window **W_{E}** by a few microseconds, due to the durations of the reset and reading steps.

As mentioned above, the method for the detection of radiations by means of a solid-state radiation sensor **1** according to the preferred embodiment described above, including all the envisaged variants, is also part of the invention.

In particular, the method of the invention provides for performing, for each pixel **3,** in sequence and periodically, a pre-charging step **200,** an exposure step **201** and a reading step **202.**

The pre-charging step provides for placing in operating mode the first electronic switch **6** and the second electronic switch **10,** so as to impose on the first common node **A** the voltage **Vdd** and, likewise, so as to impose on the second common node **B** the voltage **Vgnd.**

As mentioned above, this makes it possible to establish for the first detection transistor **4** a voltage Vgs between the gain terminal **43** and the source terminal **41** with lower value or, at most, equal to zero.

Furthermore, such a pre-charging step **200** makes it possible to establish for the second detection transistor **8** a voltage Vgs between the gain terminal **83** and the source terminal **81** with greater value or, at most, equal to zero.

These two voltage values then cause a polarization of both the above-mentioned detection transistors **4** and **8** in the cut-off region.

Even more specifically, since, as seen above, the voltage **Vdd** imposed on the first common node **A** is higher than the higher voltage **Vhigh** by a predetermined value **ΔV,** the voltage Vgs between the gain terminal **83** and the source terminal **81** of the second detection transistor **8** is positive, while, since the voltage **Vgnd** imposed on the second common node **B** is lower than the lower voltage **Vlow** of the aforesaid value **ΔV,** the voltage Vgs between the gain terminal **43** and the source terminal **41** of the first detection transistor **4** is negative, thus placing both MOS capacitors that define the two detection transistors **4** and **8** in the accumulation region.

This aspect, advantageously, allows to completely close the channel of the two detection transistors **4** and **8,** preventing in an absolute manner the passage of sub-threshold currents, also known as leakage currents, between the drain and source terminals of each of the aforesaid two detection transistors **4** and **8,** which on the contrary could inevitably lead to a change of state of the same detection transistors **4** and **8.**

Evidently, as long as the two common nodes **A** and **B** are operationally connected respectively with the first supply line **5** of voltage **Vdd** and with the second supply line **9** of voltage **Vgnd,** the two detection transistors **4** and **8** are forcibly maintained in a cut-off condition.

However, according to the invention, in order to be able to make such detection transistors **4** and **8** capable of detecting the incidence of a radiation, or of a particle, the method of the invention provides for placing in cut-off mode both the first electronic switch **6** and the second electronic switch **10,** so as to make both the first common node **A** and the second common node **B** float.

At this point, these common nodes **A** and **B,** which are physically defined by the junctions p-n of the two detection transistors **4** and **8,** are sensitive to radiations, in particular to particles, which possibly impact against these sensitive parts of each pixel **3.**

In fact, in the event that a particle impacts, during this exposure step, the sensitive part of at least one of the two detection transistors **4** and **8,** for example the first detection transistor **4,** this impact generates charges at the junction p-n of the same detection transistor **4,** which in turn cause a current spike that crosses the junction p-n. Since as seen above, at both the first common node **A** and the second common node **B,** the two detection transistors **4** and **8** are connected in feedback, this current spike will be imposed at the input, i.e. at the gate terminal of the other detection transistor, for example at the gate terminal **83** of the second detection transistor **8.** Accordingly, such a current spike, if it has adequate amplitude and duration, will also be able to place such a second detection transistor **8** in the operation region. In turn, then, the second detection transistor **8** will impose at input to the first detection transistor **4,** i.e. at the gate **43** of the first detection transistor **4,** a current sufficient to maintain or bring back into operating mode also said first detection transistor **4.**

This then results in a change of state of both such detection transistors **4** and **8** that will be detected at the end of the aforesaid exposure step **201,** during the aforesaid reading step **202.**

This phenomenon is evidently triggered, as mentioned above, when the magnitude of the charges generated by the incidence of a radiation on at least one of the two detection transistors **4** and **8** is sufficient to bring the voltage Vgs between gate and source, for example of the second detection transistor **8,** beyond the threshold value.

Furthermore, since, as mentioned above, the voltage Vgs imposed on both the detection transistors **4** and **8** in the pre-charging step **200** is such that the same detection transistors **4** and **8** are in the accumulation region, any triggering of spurious spikes due to the sub-threshold currents is avoided.

At the end of the aforesaid time window **W_{E}** of the exposure step **201,** as just mentioned, a step **202** of reading the states of the two detection transistors **4** and **8** for each pixel **3** is performed. In particular, the signal read corresponds to a binary signal, i.e. to the value "0" in the event that both the detection transistors **4** and **8** are cut-off and to the value "1" in the event that the aforesaid detection transistors **4** and **8** are in operating mode, i.e. in the event that a sufficiently intense radiation has impacted against the specific pixel **3.**

With regard to the step **202** of reading the states of the two detection transistors **4** and **8** for each pixel **3** of the radiation sensor **1,** it could envisage, according to a preferred implementing embodiment, scanning the various pixels **3.** The logic signal of each pixel **3** is discriminated by thresholding starting from the value set on the aforesaid supply lines **5** and **9.** These supply lines **5** and **9** are pre-charged to a default value before each reading. Once selected, each pixel **3** writes its state on the aforesaid supply lines **5** and **9,** while a comparator (which could simply be made by an inverter or a "sense amplifier") discriminates and amplifies the signal that will then be sampled by means of a local memory on each column at the end of the operation. The stored data will then be sent by means of a serial or parallel reading organized into groups of **8** or more bits. Since the information is differential, the reading can take place in a differential way in order to strengthen the procedure itself. However, alternatively, only the value written in the second supply line **9** could be used. Finally, it is not excluded that reading techniques and circuit implementations that are completely similar to the ones used for the memories could be used.

At the end of this reading step **202,** as mentioned above, the method of the invention provides for repeating the three steps cyclically and then, as a first step, provides for performing the aforesaid pre-charging step **200** again.

In this regard, as mentioned above, it is also important to appropriately define the duration of the time window **W_{T}** of each cycle, as the shorter this duration is and the less the probability will be of spurious current spikes being triggered on one or more pixels **3,** due to for example so-called "dark" events such as the above-mentioned sub-threshold currents or leakage. This, together with the fact of setting in the pre-charging step **200** a negative voltage Vgs for the first detection transistor **4** and a positive voltage for the second detection transistor **8,** advantageously allows to raise the detection factor of events triggered by real radiations that affects the pixel, compared to the triggering of events due to such spurious spikes.

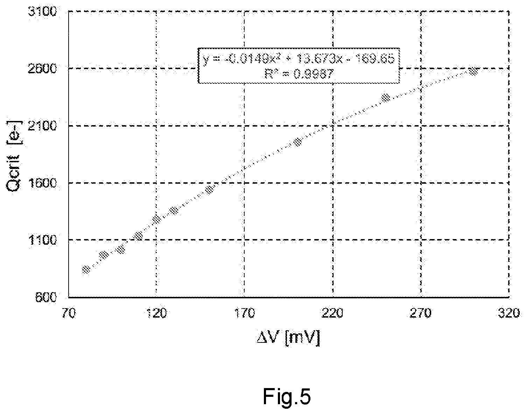

From experiments carried out by the applicants, it was found, as understandable from the graph of fig. 5, that, by keeping the value of the higher reference voltage **Vhigh** constant around 1.2V and acting on the value of **ΔV,** it is possible to define the amount of critical charge Qcrit that is sufficient and necessary to trigger an event in each of the pixels 3 that make up the radiation sensor **1** of the invention.

In particular, it can be observed that, by reducing the value of **ΔV** below 100 mV, it is possible to increase the sensitivity of each pixel **3** up to a critical charge value Qcrit around 1ke-.

From what has been said and illustrated, it can be therefore understood that the radiation sensor of the invention and the method for the detection of radiations achieve all the purposes that have been set.

In particular, the object of realizing a sensor of radiations, in particular of particles, with the sensitive elements (pixels) having a much smaller size than the sensitive elements of the radiation sensors of the known type is achieved. Thus, the object of realizing a sensor of radiations, in particular of particles, having a higher spatial resolution than the radiation sensors of the prior art is also achieved.

A further object to realize a purely digital sensor is also achieved. This, as a first effect, allows the reduction of complexity in terms of the number of transistors and controls.

In addition, the object of realizing a radiation sensor capable of maximising, in perspective, thanks to the digital approach, the technological scalability of its constituent components is also achieved.

Furthermore, the object of realizing a radiation sensor that outputs an amount of reduced information of a digital type, which therefore do not need conversion and that are quickly processable and storable, while maintaining a high spatial and temporal resolution is also achieved.

Finally, the object of realizing a radiation sensor with reduced consumptions is also achieved.

## Claims

1. Solid-state radiation sensor (1) for the detection of radiations, in particular of particles, of the type comprising at least one pixel (3) sensitive to said radiations, **characterized in that** said pixel (3) comprises:
- a first detection transistor (4) of the n-channel MOSFET type having the source terminal (41) connected to a lower voltage reference Vlow and the drain terminal (42) connected to a first supply line (5) of voltage Vdd by interposition of a first electronic switch (6) controlled by means of a first reset line (7);
- a second detection transistor (8) of the p-channel MOSFET type having the source terminal (81) connected to a higher voltage reference Vhigh, the drain terminal (82) connected to a second supply line (9) of voltage Vgnd by interposition of a second electronic switch (10) controlled by means of a second reset line (11), and the gate terminal (83) connected to a first common node (A) with the drain terminal (42) of said first detection transistor (4), said first detection transistor (4) having the gate terminal (43) connected to a second common node (B) with the drain terminal (82) of said second detection transistor (8);
wherein said voltage Vdd is equal to said higher voltage Vhigh + a voltage ΔV, and said voltage Vgnd is equal to said lower voltage Vlow - said voltage ΔV, and wherein said voltage ΔV is greater than or equal to 0V;
said radiation sensor (1) further comprising a logic unit (12) configured to perform in sequence and periodically:
- a pre-charging step (200), placing in operating mode said first electronic switch (6) and said second electronic switch (10) so as to impose on said first common node (A) said voltage Vdd and so as to impose on said second common node (B) said voltage Vgnd, so as to polarize the first detection transistor (4) and the second detection transistor (8) in the cut-off region;
- a step of exposure (201) of said pixel (3) to said radiations, placing in cut-off mode said first electronic switch (6) and said second electronic switch (10), so as to make said first common node (A) and said second common node (B) float;
- a step (202) of reading the state of said first detection transistor (4) and of said second detection transistor (8).

2. Solid-state radiation sensor (1) according to claim 1, **characterized in that** it comprises a plurality of said pixels (3) arranged in a matrix so as to define a plurality of columns (31) along a first direction (X) and a plurality of rows (32) along a second direction (Y).

3. Solid-state radiation sensor (1) according to claim 2, **characterized in that** said first supply line (5) of said voltage Vdd and said second supply line (9) of said voltage Vgnd are connected to each pixel (3) of said plurality of pixels (3).

4. Solid-state radiation sensor (1) according to claim 2, **characterized in that** it comprises a plurality of first supply lines (5) of said voltage Vdd equal to the number of said columns (31) and a plurality of second supply lines (9) of said voltage Vgnd equal to the number of said columns (31), each of said columns (31) being connected to only one of said first supply lines (5) of said voltage Vdd and to only one of said second supply lines (9) of said voltage Vgnd.

5. Solid-state radiation sensor (1) according to any one of the preceding claims, **characterized in that** said at least one pixel (3) is made on a semiconductor layer (2) of said radiation sensor (1).

6. Solid-state radiation sensor (1) according to any one of the preceding claims, **characterized in that** said voltage ΔV is greater than 0V.

7. Solid-state radiation sensor (1) according to claim 6, **characterized in that** said voltage ΔV has a value between 50 mV and 300 mV, more preferably between 150 mV and 200 mV.

8. Solid-state radiation sensor (1) according to any one of the preceding claims, **characterized in that:**
- said first electronic switch (6) is a p-channel MOSFET transistor connected with the drain terminal (61) to said first supply line (5) of said voltage Vdd, with the source terminal (62) connected to the drain terminal (42) of said first detection transistor (4) and with the gate terminal (63) connected to said first reset line (7);
- said second electronic switch (10) is an n-channel MOSFET transistor connected with the drain terminal (101) to said second supply line (9) of said voltage Vgnd, with the source terminal (102) connected to the drain terminal (82) of said second detection transistor (8) and with the gate terminal (103) connected to said second reset line (11).

9. Solid-state radiation sensor (1) according to any one of the preceding claims, **characterized in that** said exposure step (201) has a time window (W_{E}) with a duration between 50 µs and 30 ms.

10. Method for the detection of radiations by means of a solid-state radiation sensor (1) according to any one of the preceding claims, **characterized by** providing for performing in sequence and periodically the steps of:
- placing in operating mode said first electronic switch (6) and said second electronic switch (10), so as to impose on said first common node (A) said voltage Vdd and so as to impose on said second common node (B) said voltage Vgnd, so as to polarize the first detection transistor (4) and the second detection transistor (8) in the cut-off region;
- exposing said pixel (3) to said radiations, placing in cut-off mode said first electronic switch (6) and said second electronic switch (10), so as to make said first common node (A) and said second common node (B) float;
- reading the state of said first detection transistor (4) and of said second detection transistor (8).

## Patentansprüche

1. Festkörper-Strahlungssensor (1) für die Erfassung von Strahlungen, insbesondere von Partikeln, vom Typ, der mindestens ein Pixel (3) umfasst, das gegenüber den besagten Strahlungen empfindlich ist, **dadurch gekennzeichnet, dass** das besagte Pixel (3) Folgendes umfasst:
- einen ersten Erfassungstransistor (4) vom n-Kanal-MOSFET-Typ, dessen Source-Anschluss (41) mit einer niedrigeren Spannungsreferenz **Vlow** verbunden ist und dessen Drain-Anschluss (42) unter Zwischenschaltung eines ersten elektronischen Schalters (6), der mittels einer ersten Rücksetzleitung (7) gesteuert wird, mit einer ersten Versorgungsleitung (5) der Spannung Vdd verbunden ist;
- einen zweiten Erfassungstransistor (8) vom p-Kanal-MOSFET-Typ, dessen Source-Anschluss (81) mit einer höheren Spannungsreferenz Vhigh verbunden ist, dessen Drain-Anschluss (82) unter Zwischenschaltung eines zweiten elektronischen Schalters (10), der mittels einer zweiten Rücksetzleitung (11) gesteuert wird, mit einer zweiten Versorgungsleitung (9) der Spannung Vgnd verbunden ist und dessen Gate-Anschluss (83) an einem ersten gemeinsamen Knoten (A) mit dem Drain-Anschluss (42) des besagten ersten Erfassungstransistors (4) verbunden ist, wobei der Gate-Anschluss (43) des besagten ersten Erfassungstransistors (4) an einem zweiten gemeinsamen Knoten (B) mit dem Drain-Anschluss (82) des besagten zweiten Erfassungstransistors (8) verbunden ist;
wobei die besagte Spannung Vdd gleich der besagten höheren Spannung Vhigh + einer Spannung ΔV ist und die besagte Spannung Vgnd gleich der besagten niedrigeren Spannung Vlow - der besagten Spannung ΔV ist und wobei die besagte Spannung ΔV größer als oder gleich 0V ist;
wobei der besagte Strahlungssensor (1) ferner eine Logikeinheit (12) umfasst, die konfiguriert ist, um folgende Schritte sequenziell und periodisch auszuführen:
- einen Vorladeschritt (200), in dem der besagte erste elektronische Schalter (6) und der besagte zweite elektronische Schalter (10) in den Betriebsmodus versetzt werden, sodass die besagte Spannung Vdd an den besagten ersten gemeinsamen Knoten (A) angelegt wird und die besagte Spannung Vgnd an den besagten zweiten gemeinsamen Knoten (B) angelegt wird, sodass der erste Erfassungstransistor (4) und der zweite Erfassungstransistor (8) im Abschaltbereich polarisiert werden;
- einen Schritt (201) der Exposition des besagten Pixels (3) gegenüber den besagten Strahlungen, wobei der besagte erste elektronische Schalter (6) und der besagte zweite elektronische Schalter (10) in den Abschaltmodus versetzt werden, um den besagten ersten gemeinsamen Knoten (A) und den besagten zweiten gemeinsamen Knoten (B) schweben zu lassen;
- einen Schritt (202) des Lesens des Zustands des besagten ersten Erfassungstransistors (4) und des besagten zweiten Erfassungstransistors (8).

2. Festkörper-Strahlungssensor (1) nach Patentanspruch 1, **dadurch gekennzeichnet, dass** er eine Vielzahl der besagten Pixel (3) umfasst, die in einer Matrix derart angeordnet sind, um eine Vielzahl von Spalten (31) entlang einer ersten Richtung (X) und eine Vielzahl von Zeilen (32) entlang einer zweiten Richtung (Y) zu definieren.

3. Festkörper-Strahlungssensor (1) nach Patentanspruch 2, **dadurch gekennzeichnet, dass** die besagte erste Versorgungsleitung (5) der besagten Spannung Vdd und die besagte zweite Versorgungsleitung (9) der besagten Spannung Vgnd mit jedem Pixel (3) der besagten Vielzahl von Pixeln (3) verbunden sind.

4. Festkörper-Strahlungssensor (1) nach Patentanspruch 2, **dadurch gekennzeichnet, dass** er eine Vielzahl von ersten Versorgungsleitungen (5) der besagten Spannung Vdd gleich der Anzahl der besagten Spalten (31) und eine Vielzahl von zweiten Versorgungsleitungen (9) der besagten Spannung Vgnd gleich der Anzahl der besagten Spalten (31) umfasst, wobei jede der besagten Spalten (31) mit nur einer der besagten ersten Versorgungsleitungen (5) der besagten Spannung Vdd und mit nur einer der besagten zweiten Versorgungsleitungen (9) der besagten Spannung Vgnd verbunden ist.

5. Festkörper-Strahlungssensor (1) nach jeglichem der vorhergehenden Patentansprüche, **dadurch gekennzeichnet, dass** das besagte, mindestens eine Pixel (3) auf einer Halbleiterschicht (2) des besagten Strahlungssensors (1) ausgebildet ist.

6. Festkörper-Strahlungssensor (1) nach jeglichem der vorhergehenden Patentansprüche, **dadurch gekennzeichnet, dass** die besagte Spannung ΔV größer als 0V ist.

7. Festkörper-Strahlungssensor (1) nach Patentanspruch 6, **dadurch gekennzeichnet, dass** die besagte Spannung ΔV einen Wert zwischen 50 mV und 300 mV, vorzugsweise zwischen 150 mV und 200 mV, aufweist.

8. Festkörper-Strahlungssensor (1) nach jeglichem der vorhergehenden Patentansprüche, **dadurch gekennzeichnet, dass:**
- der besagte erste elektronische Schalter (6) ein p-Kanal-MOSFET-Transistor ist, dessen Drain-Anschluss (61) mit der besagten ersten Versorgungsleitung (5) der besagten Spannung Vdd verbunden ist, dessen Source-Anschluss (62) mit dem Drain-Anschluss (42) des besagten ersten Erfassungstransistors (4) verbunden ist und dessen Gate-Anschluss (63) mit der besagten ersten Rücksetzleitung (7) verbunden ist;
- der besagte zweite elektronische Schalter (10) ein n-Kanal-MOSFET-Transistor ist, dessen Drain-Anschluss (101) mit der besagten zweiten Versorgungsleitung (9) der besagten Spannung Vgnd verbunden ist, dessen Source-Anschluss (102) mit dem Drain-Anschluss (82) des besagten zweiten Erfassungstransistors (8) verbunden ist und dessen Gate-Anschluss (103) mit der besagten zweiten Rücksetzleitung (11) verbunden ist.

9. Festkörper-Strahlungssensor (1) nach jeglichem der vorhergehenden Patentansprüche, **dadurch gekennzeichnet, dass** der besagte Schritt (201) der Exposition ein Zeitfenster (W_{E}) mit einer Dauer zwischen 50 µs und 30 ms aufweist.

10. Verfahren für die Erfassung von Strahlungen mittels eines Festkörper-Strahlungssensors (1) nach jeglichem der vorhergehenden Patentansprüche, **dadurch gekennzeichnet, dass** es das sequenzielle und periodische Ausführen der folgenden Schritte vorsieht:
- Versetzen des besagten ersten elektronischen Schalters (6) und des besagten zweiten elektronischen Schalters (10) in den Betriebsmodus, sodass die besagte Spannung Vdd an den besagten ersten gemeinsamen Knoten (A) angelegt wird und die besagte Spannung Vgnd an den besagten zweiten gemeinsamen Knoten (B) angelegt wird, sodass der erste Erfassungstransistor (4) und der zweite Erfassungstransistor (8) im Abschaltbereich polarisiert werden;
- Exponieren des besagten Pixels (3) gegenüber den besagten Strahlungen, wobei der besagte erste elektronische Schalter (6) und der besagte zweite elektronische Schalter (10) in den Abschaltmodus versetzt werden, um den besagten ersten gemeinsamen Knoten (A) und den besagten zweiten gemeinsamen Knoten (B) schweben zu lassen;
- Lesen des Zustands des besagten ersten Erfassungstransistors (4) und des besagten zweiten Erfassungstransistors (8).

## Revendications

1. Capteur de rayonnement à l'état solide (1) pour la détection de rayonnements, en particulier de particules, du type comprenant au moins un pixel (3) sensible auxdits rayonnements, **caractérisé en ce que** ledit pixel (3) comprend:
- un premier transistor de détection (4) du type MOSFET à canal N dont la borne source (41) est reliée à une référence de tension inférieure Vlow et la borne drain (42) est reliée à une première ligne d'alimentation (5) de tension Vdd par l'interposition d'un premier interrupteur électronique (6) commandé au moyen d'une première ligne de réinitialisation (7);
- un deuxième transistor de détection (8) du type MOSFET à canal P dont la borne source (81) est reliée à une référence de tension supérieure Vhigh, la borne drain (82) est reliée à une deuxième ligne d'alimentation (9) de tension Vgnd par l'interposition d'un deuxième interrupteur électronique (10) commandé au moyen d'une deuxième ligne de réinitialisation (11), et la borne grille (83) reliée à un premier nœud commun (A) avec la borne drain (42) dudit premier transistor de détection (4), ledit premier transistor de détection (4) ayant la borne grille (43) reliée à un deuxième nœud commun (B) avec la borne drain (82) dudit deuxième transistor de détection (8);
où ladite tension Vdd est égale à ladite tension supérieure Vhigh + une tension ΔV, et ladite tension Vgnd est égale à ladite tension inférieure Vlow - ladite tension ΔV, et où ladite tension ΔV est supérieure ou égale à 0V;
ledit capteur de rayonnement (1) comprenant en outre une unité logique (12) configurée pour exécuter en séquence et périodiquement:
- une étape de précharge (200), consistant à mettre en mode de fonctionnement ledit premier interrupteur électronique (6) et ledit deuxième interrupteur électronique (10) de manière à imposer sur ledit premier nœud commun (A) ladite tension Vdd et de manière à imposer sur ledit deuxième nœud commun (B) ladite tension Vgnd, de manière à polariser le premier transistor de détection (4) et le deuxième transistor de détection (8) dans la zone de coupure;
- une étape d'exposition (201) dudit pixel (3) auxdits rayonnements, en mettant en mode coupure ledit premier interrupteur électronique (6) et ledit deuxième interrupteur électronique (10), de manière à faire flotter ledit premier nœud commun (A) et ledit deuxième nœud commun (B);
- une étape (202) de lecture de l'état dudit premier transistor de détection (4) et dudit deuxième transistor de détection (8).

2. Capteur de rayonnement à l'état solide (1) selon la revendication 1, **caractérisé en ce qu'**il comprend une pluralité desdits pixels (3) disposés en matrice de manière à définir une pluralité de colonnes (31) selon une première direction (X) et une pluralité de rangées (32) selon une deuxième direction (Y).

3. Capteur de rayonnement à l'état solide (1) selon la revendication 2, **caractérisé en ce que** ladite première ligne d'alimentation (5) de ladite tension Vdd et ladite deuxième ligne d'alimentation (9) de ladite tension Vgnd sont reliées à chaque pixel (3) de ladite pluralité de pixels (3).

4. Capteur de rayonnement à l'état solide (1) selon la revendication 2, **caractérisé en ce qu'**il comprend une pluralité de premières lignes d'alimentation (5) de ladite tension Vdd égale au nombre desdites colonnes (31) et une pluralité de deuxièmes lignes d'alimentation (9) de ladite tension Vgnd égale au nombre desdites colonnes (31), chacune desdites colonnes (31) étant reliée à une seule desdites premières lignes d'alimentation (5) de ladite tension Vdd et à une seule desdites deuxièmes lignes d'alimentation (9) de ladite tension Vgnd.

5. Capteur de rayonnement à l'état solide (1) selon l'une quelconque des revendications précédentes, **caractérisé en ce que** ledit au moins un pixel (3) est réalisé sur une couche semi-conductrice (2) dudit capteur de rayonnement (1).

6. Capteur de rayonnement à l'état solide (1) selon l'une quelconque des revendications précédentes, **caractérisé en ce que** ladite tension ΔV est supérieure à 0V.

7. Capteur de rayonnement à l'état solide (1) selon la revendication 6, **caractérisé en ce que** ladite tension ΔV a une valeur comprise entre 50 mV et 300 mV, plus préférentiellement entre 150 mV et 200 mV.

8. Capteur de rayonnement à l'état solide (1) selon l'une quelconque des revendications précédentes, **caractérisé en ce que:**
- ledit premier interrupteur électronique (6) est un transistor MOSFET à canal P relié avec la borne drain (61) à ladite première ligne d'alimentation (5) de ladite tension Vdd, avec la borne source (62) reliée à la borne drain (42) dudit premier transistor de détection (4) et avec la borne grille (63) reliée à ladite première ligne de réinitialisation (7);
- ledit deuxième interrupteur électronique (10) est un transistor MOSFET à canal N relié avec la borne drain (101) à ladite deuxième ligne d'alimentation (9) de ladite tension Vgnd, avec la borne source (102) reliée à la borne drain (82) dudit deuxième transistor de détection (8) et avec la borne grille (103) reliée à ladite deuxième ligne de réinitialisation (11).

9. Capteur de rayonnement à l'état solide (1) selon l'une quelconque des revendications précédentes, **caractérisé en ce que** ladite étape d'exposition (201) présente une fenêtre temporelle (W_{E}) d'une durée comprise entre 50 µs et 30 ms.

10. Procédé de détection de rayonnements au moyen d'un capteur de rayonnements à l'état solide (1) selon l'une quelconque des revendications précédentes, **caractérisé en ce qu'**il prévoit d'effectuer en séquence et périodiquement les étapes consistant à:
- mettre en mode de fonctionnement ledit premier interrupteur électronique (6) et ledit deuxième interrupteur électronique (10), de manière à imposer audit premier nœud commun (A) ladite tension Vdd et de manière à imposer audit deuxième nœud commun (B) ladite tension Vgnd, de manière à polariser le premier transistor de détection (4) et le deuxième transistor de détection (8) dans la zone de coupure;
- exposer ledit pixel (3) auxdits rayonnements, mettre en mode coupure ledit premier interrupteur électronique (6) et ledit deuxième interrupteur électronique (10), de manière à faire flotter ledit premier nœud commun (A) et ledit deuxième nœud commun (B);
- lire l'état dudit premier transistor de détection (4) et dudit deuxième transistor de détection (8).
